# EUROPEAN PATENT SPECIFICATION

(11) **EP 1 856 303 B1**
(45) Date of publication and mention of the grant of the patent: **07.01.2009**
(21) Application number: 06708475.6
(22) Date of filing: 23.02.2006
(51) Int. Cl.: C23C 14/34, H01J 37/34

(54) **SINGLE, RIGHT-ANGLED END-BLOCK**
IN RECHTEM WINKEL ANGEORDNETER EINZELENDBLOCK
BLOC SIMPLE ET A ANGLE DROIT

(30) Priority: 11.03.2005 EP 05101906
(43) Date of publication of application: 21.11.2007
(73) Proprietor: Bekaert Advanced Coatings, 9800 Deinze (BE)
(72) Inventor: DELLAERT, Krist, B-9620 Zottegem (BE); DE BOSSCHER, Wilmert, B-9031 Drongen (BE); DE BOEVER, Joannes, B-9800 Deinze (BE); LAPEIRE, Gregory, B-8560 Moorsele (BE)
(74) Representative: Messely, Marc
(86) International application number: PCT/EP2006/060216
(87) International publication number: WO 2006/094905

(56) References cited:
- US-A- 5 096 562
- US-A- 5 725 746
- US-A1- 2003 173 217

## Description

### Field of the invention.

The invention relates to an end-block that is used to rotatably carry a sputtering target in a sputtering apparatus. More in particular it relates to an end-block that integrates all supply functions in one, while the target is mounted substantially parallel to the end-block flange by which it is mounted to the wall of the sputtering apparatus.

### Background of the invention.

'Sputter deposition' or 'sputtering' is a coating process in which atoms are dislodged from a target by impingement with kinetic ions and subsequent ejection of those atoms to a substrate. The ions are generated in a free electron plasma ignited in a low pressure sputter gas (usually a noble gas species with a high atomic mass such as argon) by a voltage difference between the cathodic target and an anode. The voltage difference also accelerates the ions to a high kinetic energy towards the target. Only a minor part of the ions' kinetic energy is used to bounce target atoms out of place: the main part of the energy transfers to heat.

In order to localise the plasma as much as possible in the vicinity of the target, magnetic fields generated by magnet arrays are introduced to confine the gas ionisation in a closed-on-itself racetrack. The process is therefore called "magnetron sputter deposition". Erosion of the target then preferably takes place underneath this localised plasma. In order to make optimal use of the target material, a relative motion between plasma and target may be introduced. This can be done by moving the magnet array and keeping the target stationary relative to the sputtering apparatus or by moving the target and keeping the magnet array fixed with respect to the sputtering apparatus. The latter solution is practically implemented by using a tubular target that rotates around a fixed magnet array. The invention relates to this type of rotating tubular magnetron sputtering apparatus.

Groundbreaking state-of-the art was first described by Kelvey in a series of US patents the most noteworthy being 4356073, 4422916,4443318, 4445997. In the scaling up of these ideas, inventors were confronted with different problems such as:
- the need for a suitable drive system that also allows for a convenient target exchange
- the need for a reliable, electrical contact means that is rotatable and able to sustain large currents (sometimes more than 100 A).
- the need for a bearing system as the tubular target must be rotated (some targets have a mass of more than 200 kg).
- the need for a leak-proof cooling system. As most of the energy is transferred to heat the cooling system must be able to drain off a lot of heat. Depending on the magnitude of the installation this can be vary between 1 kW to 300 kW.
- Vacuum integrity must be maintained. As the target rotates in a low-pressure environment (between 1 and 10⁻⁴ Pa) this is not evident.
- As usually a magnet array is situated inside the rotating target, means must be provided to hold the magnet array stationary in the rotating target tube.

Solutions to these problems and implementation of them have roughly evolved along two different tracks:
- Double, right-angled end-blocks such as disclosed in US 5,096,562 (fig. 2, fig. 6) and US 2003/0136672 A1 wherein the means for bearing, rotating, energising, cooling and isolation (air, coolant and electrical) are divided between two blocks, situated at either end of the target. With right-angled is meant that the end-blocks are mounted to a wall of the sputtering apparatus that is parallel to the rotation axis of the target.
- Single, straight-through end-blocks such as disclosed in US 5,200,049 (fig. 1) wherein the means for bearing, rotating, energising, cooling and isolation are all incorporated in one end-block and the target is held cantilevered inside the large area coater. With 'straight-through' is meant that the rotation axis of the target is perpendicular to the wall on which the end-block is mounted.

Tubular, rotating magnetron arrangements have since Kelvey emerged in all kinds and sizes. The largest of them appear on large area glass coating lines in which targets with a length of up to 4 meters are used. Smaller sized installations (say with targets less than 1 meter) have not enjoyed such a widespread use, although they could improve processing of smaller substrates such as for example the size of a liquid crystal display or plasma display. One of the drawbacks in using these tubular targets in such display coaters is the need for extensive modification of the currently existing equipment.

Nowadays, elongated planar magnetron sputtering targets are used in display coaters. Most of the ancillaries (cooling means, magnet array, current supply) are mounted in a target holder that is accessible from the outside of a door, while the target parallelly faces the substrate at the inside of the apparatus when the door is closed. The substrates are mounted substantially vertical under a slant angle of about 7° to 15° and are positioned on a conveyor system on which they lean.

To make tubular magnetrons available for display coaters (be it on original equipment or as a retrofit to an existing apparatus) some problems have to be solved:
- The length occupied by end-blocks for tubular magnetrons has to be minimised.
- In order to minimise vacuum leaks, the tubular magnetron assembly should have a low number of feed through connections
- 'Quick-connectors' between target and end-block exist for tubular targets. However, the coolant that is present in the target tube when the tube is exchanged must be drained off with zero spillage.

The inventors have therefore devised a new end-block that solves the above problems.

### Summary of the invention.

It is an object of the invention to provide an end-block that on its own can carry a rotatable tubular magnetron parallel to the wall on which the end-block is mounted. It is an object of the invention to provide a single end, right-angled end-block particularly suited to be mounted on a door or wall of a sputtering apparatus. It is also an object of the invention to provide an end-block with a minimum of axial length. The inventive end-block also provides for easy draining of the coolant in case the target has to be replaced.

A first aspect of the invention concerns an end-block. Such an end-block links the sputtering target in the sputtering apparatus to the outside of the sputtering apparatus. Such an end-block is mountable as a single unit on a wall or - more preferred - on a door of a sputtering apparatus. To this end the end-block is provided with a mounting flange. Such a mounting flange - that may be circular or square or rectangular in shape - must allow for a stationary, vacuum tight connection to the wall. By preference this is accomplished by a vacuum seal gasket and a flange rim bolted to the door. Another preferred approach is that the flange is circular in shape and is pressed against a door mounted connector piece by means of threaded ring. The pressure inside an end-block is higher than in the evacuable apparatus, preferably this pressure is atmospheric. Means that are removable with the target tube or the removable magnet bar assembly are considered as not to belong to the end-block. The primary function of the end-block is to carry and to revolve the target around an axis of rotation. As sputtering is performed under a low gas pressure, the end-block must be gastight at all times and surely when it is rotating. As the sputtering of the target generates a lot of heat on the target surface, the target must be cooled which is normally done with water or another suitable coolant. This coolant must be fed and evacuated through the end-block. Also the target must be fed with an electrical current in order to maintain the target above a certain electric potential. Again this electrical current must pass through the end-block. A single end-block must comprise different means in order to implement all these functions:
- A drive means to make the target rotate. Preferably this is done by means of worm-gear system, or a cylindrical gear-gear system or a conical gear-gear crossed axis system, or a pulley-belt system, or any other means known in the art to make the target rotate.
- A rotatable electrical contact means to provide electrical current to the target. This is preferably achieved by means of an electrical commutator equipped with brushes that are in sliding contact with a commutator ring. Instead of a brush-and-ring arrangement, also two rings sliding against each other can be used, or a conducting belt type of connection can be used such as a metallic belt. It is important that this sliding contact occurs in ambient atmosphere. Embodiments wherein this contact is made in the coolant (as disclosed in US 2003/0173217) or in the vacuum (as described WO/02/38826) are hereby particularly excluded.
- A number of bearing means. Depending on the weight of the target, more than one bearing means may be necessary. The person skilled in the art will readily select that type of bearings that are appropriate from the different types known such as ball bearings, roller bearings, plain bearings, axial bearings or any other type known in the art.
- A number of rotatable coolant seal means. These coolant seals ensure that coolant will not leak into the end-block or - even worse - into the vacuum apparatus while fixed and rotatable parts of an end-block turn relative to one another. In order to reduce this risk, a number of coolant seals are introduced in cascade. Typically lip seals are used as coolant seal as they are well known in the art. However, other types - without being exhaustive - of seals like mechanical face seals or labyrinth seals are not excluded.
- Finally a number of rotatable vacuum seal means are needed. These vacuum seals ensure the integrity of the vacuum while fixed and rotating parts of the end-block rotate relative to one another. A cascading series of vacuum seals - progressively protecting the vacuum - is preferred in order reduce the risk of having a vacuum leak. Again different seals are known of which the lip seal is most popular although other types of new seals - such as ferrofluidic seals - can of course be used as well. All of the above means are present in the inventive end-block. The inventive end-block differs from the state of the art in that the axis of rotation is parallel to the mounting flange (claim 1). As such it can be categorised as a right-angled, single end-block. All functionalities for rotating, cooling and energising the target are integrated in this end-block while allowing a mounting of the end-block on a wall parallel to the axis of rotation.

In a first dependent claim, the target is foreseen with an attachment means for easy detaching and attaching of the target (dependent claim 2). Such means are e.g. described in US 5591314, EP 1092109, EP 1106893, US 6375815, WO2004/085902 . Such a means comprises in general an interface ring with an inner groove having conical faces. The conical faces fit on the one side with a mounting flange on the end-block and at the other side with a rim at the end of the target. The ring can be shortened in circumference by making it out of two or more segments that can be tangentially tightened by means of screws or a quick coupling or another means. An O-ring that is clamped between target rim and end-block flange ensures vacuum and coolant tightness.

As the target has to be carried now by a single end-block, the torque on the end-block is minimised when it is used in an upright, substantially vertical position. The target can then either hang from the end-block or it can stand on the end-block. In this way the torque exerted on the end-block is much less as the lever arm is reduced (dependent claim 3). 'Substantially vertical' should be interpreted as any direction with a deviation from 0° to ab. 15° with the local vertical, this angle corresponding to the slant angle under which the substrate is mounted.

If now the end-block is mounted below the target (dependent claim 4), the coolant can conveniently be drained off from the target as it flows out of the target under gravity.

Alternatively, the end-block can be mounted substantially horizontally (dependent claim 5) an arrangement that is preferred when using short targets.

According a second aspect of the invention (independent claim 6), a sputtering apparatus is provided. Such a sputtering apparatus comprises walls that enclose an evacuable space. On one of the walls of the sputtering apparatus, the inventive end-block according claim 1 is attached. The axis of rotation of the target then becomes parallel to the wall on which the end-block is mounted.

Preferably the end-block of the sputtering apparatus has an attachement means for the target (dependent claim 7).

When a target is fully carried by the end-block, centring problems can occur upon rotation. This can be due to the torque exerted by the target on the end-block, or by the target itself that slightly deforms under heat, or a slight misalignment at the attachment means. In order to overcome these problems a small centring block can be provided at the end of the target opposite to the end-block. Such a centring block comprises a support mounted to the same wall as the end-block. On the support a friction bearing (such as pivot bearing) or a small non-fiction bearing (ball bearing, roller bearing or the like) keeps the free end of the target centred.

By preference the target is mounted substantially vertical in the sputtering apparatus (dependent claim 9). Even more preferred is that the end-block is mounted below the target in order to allow easy drainage of the coolant (dependent claim 10).

Alternatively, the target can be mounted substantially horizontally (dependent claim 11), which is possible if the target is not too long. For longer targets, a horizontally mounted target can be supported by a centring end-block as per claim 8.

### Brief description of the drawings.

The invention will now be described into more detail with reference to the accompanying drawings wherein
- FIGURE 1 is a perspective view of an end-block according the invention.
- FIGURE 2 is a schematic view cross-section of the end-block.

### Description of the preferred embodiments of the invention.

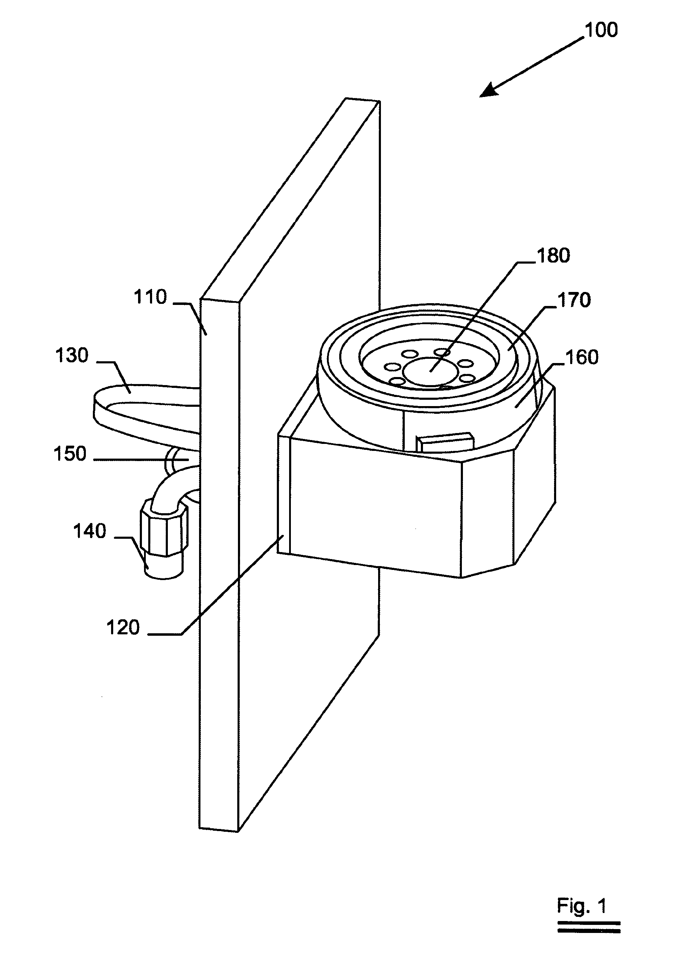

FIGURE 1 is a perspective view of how the inventive end-block is mounted to the wall or the door of a sputtering apparatus. The end-block 100 is mounted to the wall 110 of the sputtering apparatus at the end-block flange 120. From the outside of the apparatus a drive means - in this case a synchronous belt 130 - makes the mounting flange 170 rotate. The target (not shown) rests on this flange and is removably attached to it by means of an interface ring 160. Coolant supply 140 and extraction 150 at the outside connect to flange bore 180. Inside this bore the coolant supply and return are separated from one another (not visible). The magnet bar (not shown) is also inserted and held in this bore.

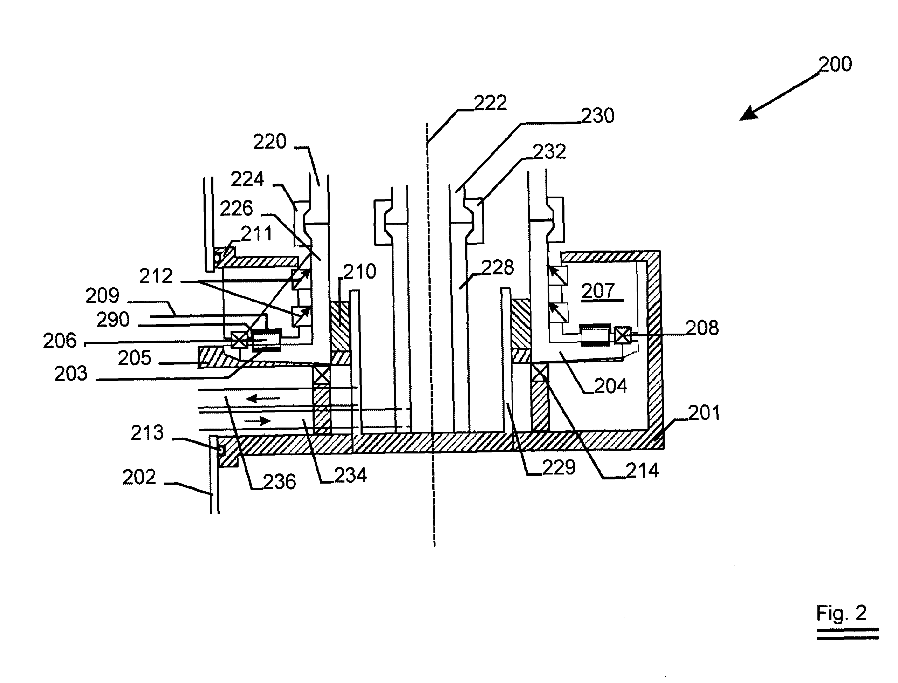

FIGURE 2 shows as schematic cross section of a preferred embodiment. The end-block 200 incorporates a drive means, a rotary electrical contact means, a bearing means, coolant sealing means and vacuum sealing means in a single housing 201. The end-block is mounted to the wall or door 202 of the sputtering apparatus through end-block flange 211. The flange is rectangular in shape and is vacuum-sealed by means of a gasket 213. The target 220 is able to rotate around its axis of rotation 222. The target 220 is connected to a target-mounting flange 226 by means of interface ring 224. The target coolant tube 230 - carrying the not shown magnet bar - is connected through the coolant feed tube 228 through an interface ring 232. The coolant feed tube 228 is firmly and fixedly attached to the end-block housing 201. The coolant is fed through coolant feed 234 into coolant tube 228. The coolant is collected in a stationary coolant collector 229, coaxial to the coolant tube 228 and is extracted through tube 236.

The target 220 is rotary driven by the gear wheel 204 through the holder ring 226 thus providing a drive means. The gear teeth engage with a worm shaft 205 that on its turn is driven by e.g. an electrical motor (not shown). The gear wheel 204 rotates an a main bearing ring 214. A second, smaller bearing 208 held between mounting ring 207 and gearwheel 204 provides additional rotational stability. The mounting ring 207 also holds a rotatable electrical contact means that is provided by a series of brushes 206 mounted as annular segments coaxial to the rotation axis 222. These brushes 206 are spring mounted in an electrically conductive ring 290 and slide against a slide ring 203. The brushes 206 receive electrical current through the conductive ring 290 that on its turn is fed by the electrical lead 209. The sliding ring 203 is in electrical contact with the target 220 through the gear 204 and the holder ring 226. Two rotatable vacuum seal means are provided by the lip seals 212. The rotatable coolant seal means is incorporated by the coolant seal 210 that is a labyrinth seal. The coolant seal 210 is mounted between the holder ring 226 and the coolant collector 229.

The person skilled-in-the-art will readily identify other possible embodiments by e.g. using other types of means than the ones described so far. Also he may rearrange the different means inside the end-block so that the axial length of the end-block is further reduced.

## Claims

1. An end-block (200) for rotatably carrying a target (220) around an axis of rotation (222) in a sputtering apparatus,
said end-block having a mounting flange (211) for mounting said end-block to said sputtering apparatus, said end-block further comprising a drive means (204), an electrical rotatable contact means, in an ambient atmosphere (206) a bearing means, a coolant seal means (210) and a vacuum seal (212) means
**characterised in that**
said end-block (200) is mountable with said axis of rotation being substantially parallel to said flange (211).

2. The end-block of claim 1 further comprising an attachment means (226) for attaching and detaching of said target.

3. The end-block according any one of claims 1 or 2 wherein said axis of rotation (222) is substantially vertical.

4. The end-block of claim 3 wherein said end-block is mounted below said target.

5. The end-block according any one of claims 1 or 2 wherein said axis of rotation is substantially horizontal.

6. A sputtering apparatus comprising walls for enclosing an evacuable space, a rotatable target having an axis of rotation and an end-block (100) for rotatably carrying said target at one end of said target, said end-block comprising a drive means, an electrical rotatable contact means, in an ambiant atmosphere, a bearing means, a coolant seal means and a vacuum seal means,
**characterised in that**
said end-block (400) is mountable to one of said walls (110) with said axis of rotation being substantially parallel to said one wall (110)

7. The sputtering apparatus of claim 6 wherein said end-block further comprises an attachment means (170) for attaching and detaching of said target

8. The sputtering apparatus according any one of claims 6 or 7 wherein said target is further held centred by a centring block, said centring block being mounted at the end of said target, opposite to the end that is carried by said end-block.

9. The sputtering apparatus according any one of claims 6 to 8 wherein said target is substantially vertically mountable.

10. The sputtering apparatus as in claim 9 wherein said end-block is mounted below said target

11. The sputtering apparatus according any one of claims 6 to 8 wherein said target is substantially horizontally mountable.

## Patentansprüche

1. Endblock (200) zum drehbaren Tragen eines Ziels (220) um eine Drehachse (222) in einer Sputtervorrichtung,
wobei der Endblock einen Befestigungsflansch (211) zur Befestigung des Endblocks an der Sputtervorrichtung aufweist, wobei der Endblock weiterhin ein Antriebsmittel (204), ein elektrisch drehbares Kontaktmittel in einer Umgebungsatmosphäre (306), ein Lagermittel, ein Kühlmitteldichtungsmittel (210) und ein Vakuumdichtungsmittel (212) aufweist,
**dadurch gekennzeichnet, dass**
der Endblock (200) so befestigt werden kann, dass sich die Drehachse im Wesentlichen parallel zum Flansch (211) befindet.

2. Endblock nach Anspruch 1, der weiterhin ein Befestigungsmittel (226) zum Befestigen und Lösen des Ziels umfasst.

3. Endblock nach einem der Ansprüche 1 oder 2, wobei die Drehachse (222) im Wesentlichen vertikal ist.

4. Endblock nach Anspruch 3, wobei der Endblock unter dem Ziel angebracht ist.

5. Endblock nach einem der Ansprüche 1 oder 2, wobei die Drehachse im Wesentlichen horizontal ist.

6. Sputtervorrichtung, die Wände zum Umschließen eines evakuierbaren Raums, ein drehbares Ziel mit einer Drehachse und einen Endblock (100) zum drehbaren Tragen des Ziels an einem Ende des Ziels umfasst, wobei der Endblock ein Antriebsmittel, ein elektrisches drehbares Kontaktmittel in einer Umgebungsatmosphäre, ein Lagermittel, ein Kühlmitteldichtungsmittel und ein Vakuumdichtungsmittel umfasst,
**dadurch gekennzeichnet, dass**
der Endblock (100) an einer der Wände (110) befestigt werden kann, wobei die Drehachse im Wesentlichen parallel zu der einen Wand (110) verläuft.

7. Sputtervorrichtung nach Anspruch 6, wobei der Endblock weiterhin ein Befestigungsmittel (170) zum Befestigen und Lösen des Ziels umfasst.

8. Sputtervorrichtung nach einem der Ansprüche 6 oder 7, wobei das Ziel weiterhin durch einen Zentrierblock zentriert gehalten wird, wobei der Zentrierblock an dem Ende des Ziels befestigt ist, das dem von dem Endblock getragenen Ende gegenüberliegt.

9. Sputtervorrichtung nach einem der Ansprüche 6 bis 8, wobei das Ziel im Wesentlichen vertikal befestigt werden kann.

10. Sputtervorrichtung nach Anspruch 9, wobei der Endblock unter dem Ziel befestigt ist.

11. Sputtervorrichtung nach einem der Ansprüche 6 bis 8, wobei das Ziel im Wesentlichen horizontal befestigt werden kann.

## Revendications

1. Bloc d'extrémité (200) destiné à porter de manière rotative une cible (220) autour d'un axe de rotation (222) dans un appareil de pulvérisation cathodique,
ledit bloc d'extrémité ayant une bride de montage (211) destinée à monter ledit bloc d'extrémité sur ledit appareil de pulvérisation cathodique, ledit bloc d'extrémité comprenant en outre un moyen d'entraînement (204), un moyen de contact rotatif électrique dans une atmosphère ambiante (206), un moyen de support, un moyen d'étanchéité pour réfrigérant (210) et un moyen d'étanchéité à vide (212),
**caractérisé en ce que**
ledit bloc d'extrémité (200) peut être monté avec ledit axe de rotation substantiellement parallèle à ladite bride (211).

2. Bloc d'extrémité selon la revendication 1, comprenant en outre un moyen de fixation (226) pour fixer et détacher ladite cible.

3. Bloc d'extrémité selon l'une quelconque des revendications 1 ou 2, dans lequel ledit axe de rotation (222) est substantiellement vertical.

4. Bloc d'extrémité selon la revendication 3, dans lequel ledit bloc d'extrémité est monté sous ladite cible.

5. Bloc d'extrémité selon l'une quelconque des revendications 1 ou 2, dans lequel ledit axe de rotation est substantiellement horizontal.

6. Appareil de pulvérisation cathodique comprenant des parois pour enfermer un espace pouvant être évacué, une cible rotative ayant un axe de rotation et un bloc d'extrémité (100) pour porter de manière rotative ladite cible à une extrémité de ladite cible, ledit bloc d'extrémité comprenant un moyen d'entraînement, un moyen de contact rotatif électrique dans une atmosphère ambiante, un moyen de support, un moyen d'étanchéité pour réfrigérant et un moyen d'étanchéité à vide,
**caractérisé en ce que**
ledit bloc d'extrémité (100) peut être monté sur l'une desdites parois (110) avec ledit axe de rotation substantiellement parallèle à ladite paroi (110).

7. Appareil de pulvérisation cathodique selon la revendication 6, dans lequel ledit bloc d'extrémité comprend en outre un moyen de fixation (170) pour fixer et détacher ladite cible.

8. Appareil de pulvérisation cathodique selon l'une quelconque des revendications 6 ou 7, dans lequel ladite cible est en outre maintenue centrée par un bloc de centrage, ledit bloc de centrage étant monté à l'extrémité de ladite cible, à l'opposé de l'extrémité portée par ledit bloc d'extrémité.

9. Appareil de pulvérisation cathodique selon l'une quelconque des revendications 6 à 8, dans lequel ladite cible peut être montée substantiellement verticalement.

10. Appareil de pulvérisation cathodique selon la revendication 9, dans lequel ledit bloc d'extrémité est monté sous ladite cible.

11. Appareil de pulvérisation cathodique selon l'une quelconque des revendications 6 à 8, dans lequel ladite cible peut être montée de manière substantiellement horizontale.
